(19) Europäisches Patentamt
European Patent Office
Office européen des brevets

(11) **EP 4 667 884 A1**

(12) **EUROPEAN PATENT APPLICATION**

(43) Date of publication:
**24.12.2025 Bulletin 2025/52**

(21) Application number: 24183041.3

(22) Date of filing: **19.06.2024**

(51) International Patent Classification (IPC):
***G01H 3/00*** *(2006.01)* ***G01H 1/00*** *(2006.01)*

(52) Cooperative Patent Classification (CPC):
**G01H 3/00;** G01H 1/003

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ABB SCHWEIZ AG**
**5400 Baden (CH)**

(72) Inventors:
• **Roivainen, Janne**
**00980 Helsinki (FI)**
• **Lyly, Mikko**
**00380 Helsinki (FI)**
• **Saarinen, Kari**
**08800 Lohja (FI)**
• **Halme, Jari**
**00960 Helsinki (FI)**
• **Westerlund, Jan**
**00380 Helsinki (FI)**
• **Sorvari, Samu**
**00380 Helsinki (FI)**

(74) Representative: **Kolster Oy Ab**
**Salmisaarenaukio 1**
**P.O. Box 204**
**00181 Helsinki (FI)**

(54) **DETERMINING VALUE INDICATING OPERATION OF ELECTRICAL MACHINE**

(57) To obtain information on operation of an electrical machine, sound data; which comprises time series of sound pressure data captured at the time the electrical machine is running at a site the electrical machine locates of the electrical machine is obtained. Further, dentification information of the electrical machine is obtained. Using the identification information, at least one parameter value stored in a digital model of the electrical machine is obtained. Then, using at least the sound data and the at least one parameter value, at least one first value indicating operation of the electrical machine is determined and displayed.

| obtain sound data | 201 |
| obtain id | 202 |
| obtain parameter value(s) in digital model | 203 |
| determine value(s) indicating operation | 204 |
| display | 205 |

*FIG.2*

EP 4 667 884 A1

## Description

FIELD

The invention relates to values indicating operation of an electrical machine, and more precisely, how to determine one or more values which indicate the operation of the electrical machine.

BACKGROUND ART

Electrical machines, for example electrical motors, can be used for fan or pump applications, for example, at industrial sites. A typical solution to find out how an electrical motor is operating at an industrial site is to install to the electrical motor one or more dedicated measurement devices, for example sensors to measure speed. However, the electrical motor may locate in a place in which installing a measurement device is difficult. It would be beneficial to find a solution that does not require installation of any measurement device to the electrical motor to determine one or more values indicating how the electrical motor is operating.

SUMMARY

The invention relates to a method, a system and a computer program, as defined in the independent claims. Further embodiments are disclosed in the dependent claims.

A general aspect introduces use of at least one parameter value in a digital model of an electrical machine and sound data of the electrical machine, captured at a vicinity of the electrical machine, to determine one or more values indicating operation of the electrical machine.

BRIEF DESCRIPTION OF THE DRAWINGS

In the following, exemplary embodiments will be described in greater detail with reference to accompanying drawings, in which

Figures 1A and 1B show simplified exemplified architecture of a system;
Figures 2 to 6 are flow charts illustrating example functionalities; and
Figure 7 is a schematic block diagram illustrating an example of an apparatus.

DETAILED DESCRIPTION OF SOME EMBODIMENTS

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments/examples to consist of only those features that have been mentioned and such embodiments may contain also features/structures that have not been specifically mentioned. Further, although terms including ordinal numbers, such as "first", "second", etc., may be used for describing various elements, the elements are not restricted by the terms. The terms are used merely for the purpose of distinguishing an element from other elements. For example, a first value could be termed a second value or a value, and similarly, a second value could be also termed a first value, or a value without departing from the scope of the present disclosure.

The present invention is applicable to any apparatus, system, or equipment that is configured or configurable to determine one or more values indicating operation of one or more electrical machines based on sound data. Different embodiments and examples are described below using single units, models, equipments, and memory, without restricting the embodiments/examples to such a solution. Concepts called cloud computing and/or virtualization may be used. The virtualization may allow a single physical computing device to host one or more instances of virtual machines that appear and operate as independent computing devices, so that a single physical computing device can create, maintain, delete, or otherwise manage virtual machines in a dynamic manner. It is also possible that device operations will be distributed among a plurality of servers, nodes, devices, or hosts. In cloud computing network devices, computing devices, and/or storage devices provide shared resources. Some other technology advancements, such as Software-Defined Networking (SDN), may cause one or more of the functionalities described below to be migrated to any corresponding abstraction or apparatus or device. Therefore, all words and expressions should be interpreted broadly, and they are intended to illustrate, not to restrict, the embodiment.

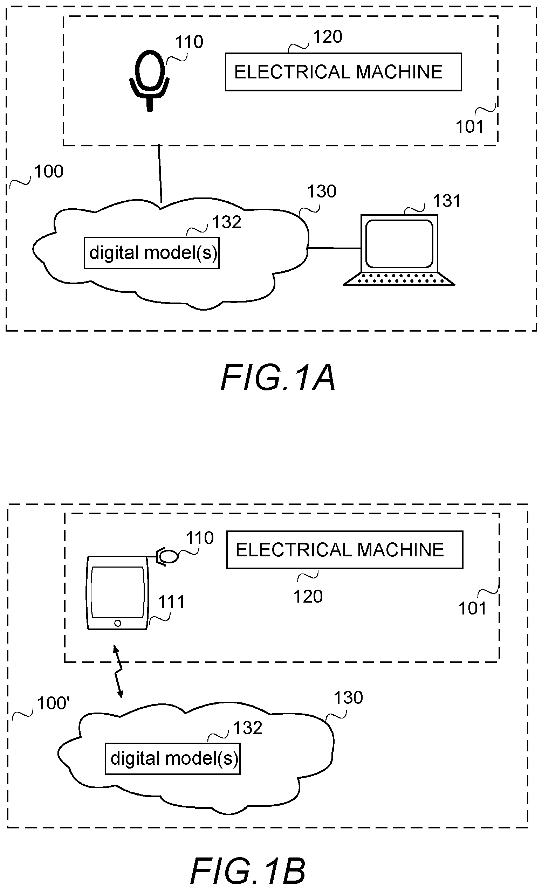

General exemplary architectures of systems are illustrated in Figures 1A and 1B. Figures 1A and 1B are simplified system architectures showing only some devices, apparatuses, and functional entities, all being logical units whose implementation and/or number may differ from what is shown. It is apparent to a person skilled in the art that a system comprises any number of shown elements, other equipment, other functions, and other structures, some of which used in or for big data, data management, and communication in the system or in one part of the system, that are not illustrated. They, as well as the protocols used, are well known by persons skilled in the art and are irrelevant to the actual invention. Therefore, they need not to be discussed in more detail here.

The connections shown in Figures 1A and 1B are logical connections; the actual physical connections may be different. The connections may be wired and/or wireless connections and a connection may be a direct connection or a connection over one or more networks. The one or more networks may be any wired or wireless network, or a combination thereof, enabling transmission of information between different apparatuses/devices over the network. These include, but are not limited to, local area networks (LAN), cellular networks, such as LTE, 3G, 4G, 5G and beyond, wireless local area networks (WLAN or WiFi), Bluetooth®, ZigBee, near field communication (NFC), and light fidelity (LiFi) networks and networks based on other technologies using at least one of visible light spectrum, ultraviolet, infrared radiation, or radio waves. However, wireless and wired connection and establishing a connection, as said above, are well known by persons skilled in the art, and no amendments to them is required. Hence, they need not to be discussed in more detail herein.

Figure 1A is a simplified system architecture of a remote server -based deployment scenario and Figure 1B is a simplified system architecture of a user apparatus -based deployment scenario. In both examples, a cloud-based storage is used as a non-limiting example of a platform and devices (servers) on which data may be stored and accessed.

In the examples of Figure 1A and Figure 1B, the system 100, 100' comprises one or more industrial sites 101 (only one illustrated in Figures 1A and 1B) connected over one or more networks (none shown in Figures 1A and 1B) to one or more clouds 130, which is used in the examples as a non-limiting example of a data storage. The details of how data are stored in the cloud or in any other shared data storage are not relevant and therefore they are not described in more detail here. It is obvious for one skilled in the art that any known or future storage method may be used. Further, implementing the examples described herein using a non-cloud deployment is a straightforward task for one skilled in the art.

In the examples of Figure 1A and Figure 1B, the industrial site 101 comprises an electrical machine 120 and one or more microphones 110, or one or more corresponding acoustic detectors or sound recording devices, positionable, and in the illustrated examples positioned, in a vicinity of the electrical machine 120, to capture sound data of the electrical machine. The sound data comprises at least time series of sound pressure data captured at the time the electrical machine is running. The sound data may also be referred as a noise.

A microphone 110 may be a movable microphone, or a non-movable microphone. Preferably, the microphone is not moved when the sound data is captured. Further, the microphone may be a standalone microphone, or a microphone comprised in an apparatus, or device, for example comprised in a smart phone, or a microphone connected to an apparatus, for example to a portable apparatus. The term "microphone" used herein covers all options listed above. Depending on an implementation, the microphone may be configured to capture the sound data and store and possibly process the sound data captured, and/or transmit the sound data captured to the cloud or to a remote service center, for example, to be stored, and/or to be processed. The storing may include establishing a wireless or wired connection to the cloud or to the remote service center. Having such a microphone 110, that is easy to place in the vicinity of the electrical motor, makes measurements easy and fast to implement.

The electrical machine 120 may be a single or a standalone electrical motor, such as a direct on line electrical motor or a variable speed drive controlled electrical motor. Such motors are used across industries, for example for fan or pump applications, for example. However, the use purpose of the electrical machine bears no significance to the disclosed ways to determine one or more values indicating operation of the electrical machine 120.

In the example of Figure 1A and in the example of Figure 1B, the data storage 132 in the cloud 130 comprises, or stores, at least digital models of electrical machines, a digital model of an electrical machine comprising parameter values of the electrical machine. A digital model may be a digital twin of the electrical machine 120. The data storage 132, or another data storage, may be used to store the sound data captured, or other information, such as product data, or process data, or earlier determined values indicating operation of the electrical machine.

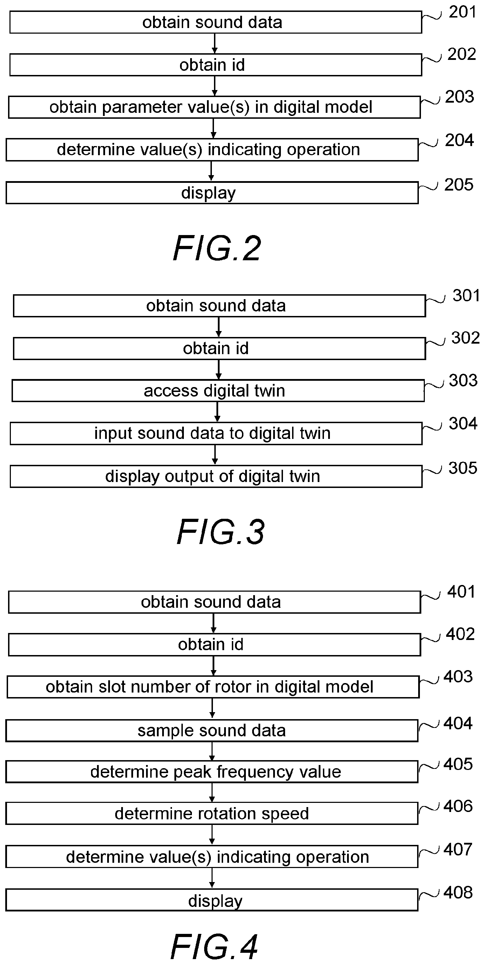

In the remote server -based deployment scenario of Figure 1A, the system 100 comprises one or more servers 131 (only one illustrated in Figure 1A), for example in a remote service center, or in a remote operation room, connected to the cloud 130 over one or more networks and connected to the industrial site 101 and/or to the microphone 110, and/or to the electrical machine via the cloud 130 and/or over one or more networks. A server 131 may be configured to determine, for example as will be described with Figures 2 to 6, at least one value indicating operation of the electrical machine 120, using the sound data captured and the digital model of the electrical machine. For example, the server may be configured to receive, via a user interface, identification information of the electrical machine, and use the identification information to retrieve the sound data, when the sound data is not received from the microphone, access the data storage 132, to obtain, using the identification information at least one parameter value of the electrical machine, determine one or more values indicating operation of the electrical machine and to display, for example via a screen, or other user interface, the one or more values determined.

In the example of Figure 1A, the microphone 110 may be configured to transmit the sound data captured to the server 131 to be stored and/or to be processed, in addition to transmitting the sound data captured to the cloud, or instead of transmitting the sound data to the cloud. The transmitting may include establishing a wireless or wired connection to the cloud 130 and/or to the server 131.

In the user apparatus -based deployment scenario of Figure 1B, representing a portable apparatus -based deployment scenario, the system 100' comprises one or more apparatuses 111 (only one illustrated in Figure 1B), for example a smart device, locating at the industrial site 101. The smart device may comprise the microphone 110, for example as part of a video capturing mechanism, or be connected to the microphone. The smart device refers to computing device (equipment, apparatus) that may be also referred to as a user apparatus. The smart device may be a portable communication device. Portable communication devices (apparatuses) include wireless mobile communication devices operating with or without a subscriber identification module (SIM) in hardware or in software, including, but not limited to, the following types of devices: mobile phone, smartphone, personal digital assistant (PDA), handset, laptop and/or touch screen computer, tablet (tablet computer), multimedia device, wearable computer, and other types of wearable devices, such as clothing and accessories incorporating computer and advanced electronic technologies.

The smart device 111 may be configured, for example by downloading an application to the smart device, to determine, for example as will be described with Figures 2 to 6, at least one value indicating operation of the electrical machine 120, using the sound data captured and the digital model of the electrical machine. For example, the smart device 111 may be configured to receive, via a user interface, identification information of the electrical machine, establish a connection to the cloud to access the data storage 132, to use the identification information to obtain at least one parameter value of the electrical machine, to capture the sound data, for example via video recording, to determine one or more values indicating operation of the electrical machine and to display, for example via a screen, or other user interface, the one or more values determined. The smart devices, e.g. smart phones, are easy to use and easy to update to comprise said application, thereby enabling fast determination, even with unskilled persons, of the one or more values indicating the operation, just by a user carrying the smart phone to the industrial site, placing it so that it will stay in place when the sound is captured, for example 10 seconds, starting the application, which triggers the sound capturing, and results to the one or more values being displayed.

More precisely, in the example of Figure 1A the server provides means for determining, using at least the sound data and at least one parameter value in a digital model of the electrical machine, at least one first value indicating operation of the electrical machine, and means for displaying the at least one first value, and in the example of Figure 1B, the smart device provides said means. However, the means may be distributed differently between different devices or apparatuses, for example a server may provide means for determining and the smart device means for displaying, or vice versa.

Figures 2 to 6 are flowcharts illustrating different example functionalities of a computing apparatus, or a tool, such as an application, comprised in and executed by the computing apparatus. The computing apparatus may be a server, or comprised in a server, or the computing apparatus may be a smart device that can locate at an industrial site, for example in a vicinity of an electrical machine in the industrial site.

Referring to Figure 2, sound data of the electrical machine is obtained (step 201), the sound data comprising time series of sound pressure data captured at the time the electrical machine is running at the site the electrical machine locates. For example, the length of the sound data may be 10 seconds. Depending on the implementation, the obtaining may comprise retrieving earlier captured sound data from a memory of the computing apparatus, or from a data storage. The obtaining may also be a real-time, or near-real time obtaining, for example by capturing, or by receiving captured data, performed while other steps are performed.

Also identification information (id) of the electrical machine is obtained (step 202). The identification information may be a serial number of the electrical machine, for example. There are a plurality of ways to obtain the identification information, the ways including a user inputting the serial number via a user interface, or reading the serial number in the site via a reading interface in the microphone (in apparatus comprising the microphone or connected to the microphone), for example by capturing a QR code by a camera, or using a near field communication interface to read it from a chip.

When the identification information has been obtained, at least one parameter value stored in a digital model of the electrical machine, is obtained (step 203), using the identification information.

Then, using at least the sound data and the at least one parameter value, at least one first value indicating operation of the electrical machine is determined (step 204) and the at least one first value is displayed (step 205) to a user.

In one example, the at least one parameter value obtained (step 203) comprises a slot number of a rotor, and the determining (step 204) the at least one first value comprises sampling the sound data, determining from sampled data a peak frequency value, and determining the at least one first value based on at least the peak frequency value and the slot number of the rotor.

Referring to Figure 3, sound data of the electrical machine is obtained (step 301), and identification information of the electrical machine is obtained (step 302), as described in more detail above with Figure 2 (step 201 and step 202). In the example of Figure 3, the digital model is a digital twin of the electrical machine. Hence, in the illustrated example of Figure 3, obtaining, using the identification information, at least one parameter value stored in a digital model of the electrical machine is part of accessing (step 303) the digital twin, which comprises parameter values. In the example of Figure 3, the determining at least one first value indicating operation of the electrical machine includes inputting (step 304) the sound data to the digital twin, which outputs the at least one first value. The output of the digital twin, i.e. the at least one first value, is then displayed (step 305) to a user.

Figures 4 to 6 describe more detailed examples how to determine the at least one first value. In the examples, the digital model is used. However, implementing the examples to the implementation in which the digital twin is used, is a straightforward task, the digital twin may be configured to process the input sound data using same principles.

In the example of Figure 4, one parameter value is used, the parameter value being a slot number of a rotor of the electrical machine. Further, in the example, the one or more first values are determined based on a rotation speed, which in turn is determined based on sound data captured.

Referring to Figure 4, sound data of the electrical machine is obtained (step 401), and identification information of the electrical machine is obtained (step 402), as described in more detail above with Figure 2 (step 201 and step 202). When the identification information has been obtained, a slot number of the rotor of the electrical machine, stored in the digital model of the electrical machine, is obtained (step 403), using the identification information.

To determine the at least one first value, the sound data is sampled (step 404), and a peak frequency value is determined (step 405) from the sampled data. Then, using the peak frequency value and the slot number of the rotor, a rotation speed of the electrical machine is determined (step 406). Hence, the rotation speed is determined without installing to the electrical machine a dedicated speed measuring sensor/device, such as a tachometer. As is known, the rotation speed is used as input in numerous analysis tasks, such as antifriction bearing fault analysis, dynamic eccentricity detection, shaft power estimation, etc. Hence, the one or more first values indicating operation of the electrical machine are determined (step 407) based on the rotation speed, the one or more first values are displayed (step 408). Any known analysis method, which uses the rotation speed, can be used, and since no amendments to the analysis methods is required, there is no need to describe them in more detail.

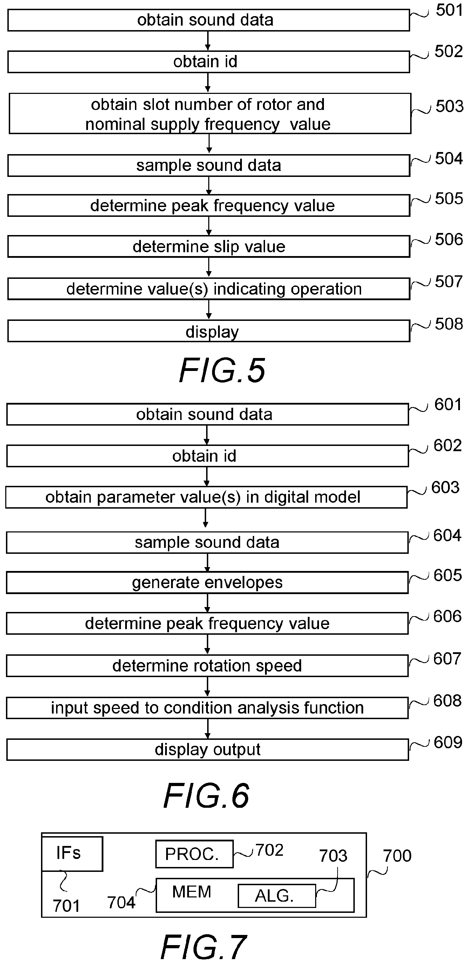

In the example of Figure 5, two parameter values are used, the parameter values being a slot number of a rotor of the electrical machine and a nominal supply frequency. Further, in the illustrated example of Figure 5, the at least one first value indicating operation comprises an operation point of the electrical machine and/or an efficiency value of the electrical machine. Further, in the example, the one or more first values are determined based on a slip value, which in turn is determined based on sound data captured. The slip refers to difference between synchronous speed of an electrical motor (nominal speed) and its actual rotating speed.

Referring to Figure 5, sound data of the electrical machine is obtained (step 501), and identification information of the electrical machine is obtained (step 502), as described in more detail above with Figure 2 (step 201 and step 202). When the identification information has been obtained, a slot number of the rotor of the electrical machine, and the nominal supply frequency of the electrical machine, both stored in the digital model of the electrical machine, are obtained (step 503), using the identification information.

To determine the at least one first value, the sound data is sampled (step 504), and a peak frequency value is determined (step 505) from the sampled data. Then, using the peak frequency value, the slot number of the rotor and the nominal supply frequency, a slip value of the electrical machine is determined (step 506). Then the operation point of the electrical machine and/or an efficiency value of the electrical machine is/are determined (step 507), based on the slip value, and displayed (step 508). Any known method, which uses the slip value when determining the operation point and/or efficiency value, can be used, and since no amendments to the analysis methods is required, there is no need to describe them in more detail.

The thus estimated direct on line slip speed value indicates also the rotation speed, when nominal rotation speed of the electrical machine is known. In one implementation, which is based on the process of Figure 5, in addition to determine the operation point and/or efficiency value, the rotation speed is determined based the slip value and nominal rotation speed, which may have been obtained as a parameter value from the digital model. The rotation speed can then be used to determine other first values which will be displayed. In another implementation, which is based on the process of Figure 5, instead of determining the operation point and/or efficiency value, the rotation speed is estimated, and based on the estimated rotation speed, one or more first values are determined and displayed.

Figure 6 describes one example how a peak frequency value may be determined. The example may be implemented with any of the above examples. Further, in the example of Figure 6, one parameter value is used, the parameter value being a slot number of a rotor of the electrical machine.

Referring to Figure 6, sound data of the electrical machine is obtained (step 601), and identification information of the electrical machine is obtained (step 602), as described in more detail above with Figure 2 (step 201 and step 202). When the identification information has been obtained, a slot number of the rotor of the electrical machine, stored in the digital model of the electrical machine, is obtained (step 603), using the identification information.

To determine the at least one first value, the sound data is sampled (step 604). In the example of Figure 6, to determine the peak frequency value, envelopes are generated and processed, resulting to an estimated peak frequency value. More precisely, envelopes for a plurality of center frequency values are generated (step 606) and a matrix is formed. Envelopes are are generated typically using as a starting frequency $f_1=f_{supplyN}*Q2/2$, wherein $f_{supplyN}$ is the nominal supply frequency of the electrical machine, to ending frequence $f_n$ = 8000 Hz, using filter bandwidth B=4*$f_{supplyN}$,.

For example, using sound data, e.g. sound pressure p(t), wherein $t=t_1...t_k$, n envelopes, starting from an envelope with frequency center $f_1$ and ending with an envelope with frequency center $f_n$, following matrix (envelope matrix) is obtained, wherein the first column is the first envelope, generated using $f_1$, and the last column is the last envelope, generated using $f_n$:

$$\begin{bmatrix} x_1(t_1) & \cdots & x_n(t_1) \\ \vdots & \ddots & \vdots \\ x_1(t_k) & \cdots & x_n(t_k) \end{bmatrix}$$

The peak frequency value is then determined, or estimated (step 606) from the envelope matrix. The peak frequency may be determined by applying to the above envelope matrix singular value decomposition or direct averaging. Both methods enable to find modulation hidden in stationary data. The singular value decomposition is more immune to noise but slower, whereas the direct is much faster but might suffer from noise in the captured sound data.

In the singular value decomposition, the envelope matrix undergoes cross-spectrum calculation/estimation, resulting to m cross spectrum matrices, starting from

$$\begin{bmatrix} G_{11}(f_1) & \cdots & G_{1n}(f_1) \\ \vdots & \ddots & \vdots \\ G_{n1}(f_1) & \cdots & G_{nn}(f_1) \end{bmatrix}$$

and ending to

$$\begin{bmatrix} G_{11}(f_m) & \cdots & G_{1n}(f_m) \\ \vdots & \ddots & \vdots \\ G_{n1}(f_m) & \cdots & G_{nn}(f_m) \end{bmatrix}$$

wherein G denotes the cross spectrum, and m may be smaller than k.

Then, per a cross spectrum, a singular value of the spectrum is determined, and a frequency associated with the cross spectrum having the highest singular value, is determined (step 606) to be the peak frequency value.

In the direct averaging, the envelope matrix undergoes auto-spectrum, resulting to following spectrum matrix, wherein F denotes the auto-spectrum

$$\begin{bmatrix} F_1(f_1) & \cdots & F_n(f_1) \\ \vdots & \ddots & \vdots \\ F_1(f_{1m}) & \cdots & F_n(f_m) \end{bmatrix}$$

Then mean spectrum, per a row, is calculated from the spectrum matrix using following formula, for example:

$$F_{mean}(f) = \frac{1}{n} \sum_{t=1}^{n} F_t(f)$$

A frequency associated with the highest mean spectrum value, is determined (step 606) to be the peak supply frequency value.

In another implementation, the peak frequency value obtained as described above is further fine tuned using for example a maximum likelihood estimator, and a fine tuned peak frequency value is determined (step 606) to be the peak frequency value.

Then, using the peak frequency value and the slot number of the rotor, a rotation speed of the electrical machine is determined (step 607), as described above with Figure 4. In the illustrated example of Figure 6, the rotation speed is inputted (step 608) to a condition analysis function outputting at least the one first value, which is then displayed (step 609).

As can be seen from the above examples, capturing sound data in a vicinity of an electrical motor, and using it, together with information of the electrical motor, provides an easy and fast way to find out how effectively the electrical motor is operating. For example, motor operation point and/or efficiency can be easily determined. Information how effectively the electrical motor is operating, e.g. the first value indicating operation of the electrical motor, may be used to improve energy efficiency, for example to find out inefficient electrical motors so that they can be replaced by newer ones, or otherwise improve a process. As said above, the captured sound data and/or the first values may be utilized for condition monitoring applications, for example for detecting fan and bearing faults.

The steps and related functions described above with respect to Figures 2 and 6 are in no absolute chronological order, and some of the steps may be performed simultaneously or in an order differing from the given one. Other functions may also be executed between the steps or within the steps. Some of the steps or parts of the steps may also be left out or replaced by a corresponding step or a part of a step.

Figure 7 is a simplified block diagram illustrating some units for an apparatus (device, equipment) 700 configured to perform at least some functionalities/operations described above, for example by means of Figures 1A to 6 and any combination thereof. In the illustrated example, the apparatus 700 comprises one or more interface (IF) entities 701, such as one or more user interfaces, and one or more processing entities 702 connected to various interface entities 701 and to one or more memories 703.

The one or more interface entities 701 are entities for receiving and transmitting information, such as communication interfaces comprising hardware and/or software for realizing communication connectivity according to one or more communication protocols, or for realizing data storing and fetching.

A processing entity 702 is capable of performing calculations and configured to implement at least part of functionalities/operations described above, for example by means of any of Figures 2 to 6 and any combination thereof, with corresponding algorithms 704 stored in the memory 703. The processing entity 702 may include one or more processors, controllers, control units, micro-controllers, etc. configurable to carry out embodiments/examples/implementations or operations described above, for example by means of any of Figures 1A to 6 and any combination thereof. Generally, a processor is a central processing unit, but the processing entity 702 may be an additional operation processor or a multicore processor or a microprocessor.

A memory 703 is usable for storing a computer program code required for one or more functionalities/operations described above, for example by means of any of Figures 2 to 6 and any combination thereof, that is, the algorithms 704 for implementing the functionalities/operations described above by means of any of Figures 2 to 6 and any combination thereof. The memory 703 may also be usable for storing, at least temporarily, other possible information required for one or more functionalities/operations described above, for example by means of any of Figures 2 to 6 and any combination thereof.

As a summary, the methods described herein, for example by means of any of Figures 1A to 6 and any combination thereof, may be configured as a computer or a processor, or a microprocessor, such as a single-chip computer element, or as a chipset, or one or more logic gates including at least a memory for providing storage area used for arithmetic operations and an operation processor for executing the arithmetic operations. Each or some or one of the algorithms for functions/operations described above, for example by means of any of Figures 1A to 6 and any combination thereof, may be comprised in one or more computer processors, application-specific integrated circuits (ASIC), digital signal processors (DSP), digital signal processing devices (DSPD), programmable logic devices (PLD), field-programmable gate arrays (FPGA), graphics processing units (GPU), and/or other hardware components that have been programmed and/or will be programmed by downloading computer program code (one or more algorithms) in such a way as to carry out one or more functions of one or more embodiments/examples.

An embodiment provides a computer program embodied on any client-readable distribution/data storage medium or memory unit(s) or article(s) of manufacture, comprising program instructions executable by one or more processors/computers, which instructions, when loaded into an apparatus (device, equipment), constitute an entity providing corresponding functionality, or at least part of the corresponding functionality. Programs, also called program products, including software routines, program snippets constituting "program libraries", applets and macros, can be stored in any medium, including non-transitory computer readable storage medium, and may be downloaded into an apparatus. In other words, each or some or one of the algorithms for one or more functions/operations described above, for example by means of any of Figures 2 to 6 and any combination thereof, may be comprised in an element that comprises one or more arithmetic logic units, a number of special registers and control circuits.

It will be obvious to a person skilled in the art that, as the technology advances, the inventive concept can be implemented in various ways. The invention and its embodiments are not limited to the examples described above but may vary within the scope of the claims.

## Claims

1. A computer-implemented method comprising:

   obtaining sound data of an electrical machine, the sound data comprising time series of sound pressure data captured at the time the electrical machine is running at an industrial site the electrical machine locates;
   obtaining identification information of the electrical machine;
   obtaining, using the identification information, at least one parameter value stored in a digital model of the electrical machine;
   determining, using at least the sound data and the at least one parameter value, at least one first value indicating operation of the electrical machine; and
   displaying the at least one first value.

2. The method of claim 1, wherein the at least one parameter value comprises a slot number of a rotor and the determining the at least one first value comprises:

   sampling the sound data;
   determining from sampled data a peak frequency value; and
   determining the at least one first value based on at least the peak frequency value and the slot number of the rotor.

3. The method of claim 2, wherein determining the peak frequency value comprises:

   generating envelopes for a plurality of center frequency values; and
   applying to the envelopes direct averaging or singular value decomposition to determine the peak frequency value.

4. The method of claim 2 or 3, further comprising:

   determining a rotation speed of the electrical machine using the peak frequency value and the slot number of the rotor; and
   determining the at least one first value based on the rotation speed.

5. The method of claim 4, wherein the determining the at least one first value based on the rotation speed comprises inputting the rotation speed to a condition analysis function outputting at least the one first value.

6. The method of claim 2, 3, 4 or 5 wherein the at least one parameter value further comprises a nominal supply frequency, and determining the at least one first value comprises:

   determining a slip value of the electronical machine;
   determining, based on the slip value, as the at least one first value to be displayed an operation point of the electrical machine and/or an efficiency value of the electrical machine.

7. The method of claim 1, wherein the digital model is a digital twin, the at least one parameter value is obtained by obtaining the digital twin, and the determining includes inputting the sound data to the digital twin, which outputs the at least one first value.

8. The method of any preceding claim, wherein the obtaining the sound data includes capturing the sound data by a mobile microphone in a vicinity of the electrical machine.

9. A system comprising at least

   an electrical machine in an industrial site;
   a microphone, positionable in a vicinity of the electrical machine and configured to capture sound data of the electrical machine, the sound data comprising time series of sound pressure data captured at the time the electrical machine is running;
   means for obtaining identification information of the electrical machine;
   data storage storing digital models of electrical machines, a digital model comprising parameter values;
means for determining, using at least the sound data and at least one parameter value in a digital model of the electrical machine, at least one first value indicating operation of the electrical machine; and
means for displaying the at least one first value.

10. The system of claim 9, wherein the means for determining are configured to carry out any of the methods of claims 2 to 6.

11. The system of claim 9 or 10, wherein the microphone is a microphone in a portable apparatus that is configured to establish wireless connections.

12. The system of claim 11, wherein the portable apparatus is a smart device, configured to access the data storage and comprises the means for determining and the means for displaying.

13. The system of claim 9, 10 or 11, the system further comprising one or more servers comprising at least the means for determining, the servers being configured to receive the sound data and to access the data storage.

14. The system of any of claims 9 to 13, wherein the electrical machine is a direct on line electrical motor.

15. A computer program comprising instructions which, when the program is executed by a computing device, cause the computing device to carry out any of the methods of claims 1 to 7.

## FIG.1A

## FIG.1B

obtain sound data ~ 201

obtain id ~ 202

obtain parameter value(s) in digital model ~ 203

determine value(s) indicating operation ~ 204

display ~ 205

*FIG.2*

obtain sound data ~ 301

obtain id ~ 302

access digital twin ~ 303

input sound data to digital twin ~ 304

display output of digital twin ~ 305

*FIG.3*

obtain sound data ~ 401

obtain id ~ 402

obtain slot number of rotor in digital model ~ 403

sample sound data ~ 404

determine peak frequency value ~ 405

determine rotation speed ~ 406

determine value(s) indicating operation ~ 407

display ~ 408

*FIG.4*

| obtain sound data | ~ 501 |
|---|---|
| obtain id | ~ 502 |
| obtain slot number of rotor and nominal supply frequency value | ~ 503 |
| sample sound data | ~ 504 |
| determine peak frequency value | ~ 505 |
| determine slip value | ~ 506 |
| determine value(s) indicating operation | ~ 507 |
| display | ~ 508 |

## FIG.5

| obtain sound data | ~ 601 |
|---|---|
| obtain id | ~ 602 |
| obtain parameter value(s) in digital model | ~ 603 |
| sample sound data | ~ 604 |
| generate envelopes | ~ 605 |
| determine peak frequency value | ~ 606 |
| determine rotation speed | ~ 607 |
| input speed to condition analysis function | ~ 608 |
| display output | ~ 609 |

## FIG.6

FIG.7

Europäisches
Patentamt

European
Patent Office

Office européen
des brevets

# EUROPEAN SEARCH REPORT

**Application Number**

EP 24 18 3041

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/176537 A1 (ORMAN MACIEJ [CN] ET AL) 22 June 2017 (2017-06-22) | 1,7-9, 11-15 | INV. G01H3/00 |
| Y | * abstract * <br> * figures 1-7 * <br> * pages 1-5 * | 2,4-6,10 | G01H1/00 |
| X | PARAMO-BALSA PAULA ET AL: "A Low-Cost Non-Intrusive Method for In-Field Motor Speed Measurement Based on a Smartphone", SENSORS, vol. 21, no. 13, 24 June 2021 (2021-06-24), page 4317, XP093221650, CH ISSN: 1424-8220, DOI: 10.3390/s21134317 | 1,8,9, 11,12, 14,15 | |
| Y | * abstract * <br> * figures 1-11 * <br> * pages 3-17 * | 2-5,10 | |
| Y | TAKASHI KOBAYASHI ET AL: "Effects of Slot Combination on Acoustic Noise from Induction Motors", IEEE TRANSACTIONS ON MAGNETICS, IEEE, USA, vol. 33, no. 2, 1 March 1997 (1997-03-01), pages 2101-2104, XP011085881, ISSN: 0018-9464, DOI: 10.1109/20.582736 * abstract * <br> * figures 1,4-7 * <br> * page 2101 - page 2104 * | 2-6,10 | |

**TECHNICAL FIELDS SEARCHED (IPC)**

G01H
G01R
G08B
G01M

The present search report has been drawn up for all claims

| Place of search | Date of completion of the search | Examiner |
|---|---|---|
| The Hague | 13 November 2024 | Meyer, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 3041

This annex lists the patent family members relating to the patent documents cited in  the above-mentioned European search report.
The members are as contained in the European Patent Office EDP file on
The European Patent Office is in no way liable for these particulars which are merely given for the purpose of information.

13-11-2024

| Patent document cited in search report | Publication date | Patent family member(s) | | Publication date |
|---|---|---|---|---|
| US 2017176537 A1 | 22-06-2017 | CN | 105472117 A | 06-04-2016 |
| | | EP | 3192166 A1 | 19-07-2017 |
| | | US | 2017176537 A1 | 22-06-2017 |
| | | WO | 2016037711 A1 | 17-03-2016 |

EPO FORM P0459

For more details about this annex : see Official Journal of the European Patent Office, No. 12/82